# EUROPÄISCHE PATENTSCHRIFT

(11) **EP 0 914 677 B1**
(45) Veröffentlichungstag und Bekanntmachung des Hinweises auf die Patenterteilung: **13.11.2002**
(21) Anmeldenummer: 97932728.5
(22) Anmeldetag: 02.07.1997
(51) Int. Cl.: H01L 21/3205, H01L 27/115

(54) **SCHICHTAUFBAU MIT EINER FERROELEKTRISCHEN SCHICHT UND HERSTELLVERFAHREN**
STRATIFIED STRUCTURE WITH A FERROELECTRIC LAYER AND PROCESS FOR PRODUCING THE SAME
STRUCTURE STRATIFORME COMPORTANT UNE COUCHE FERROELECTRIQUE ET PROCEDE DE PRODUCTION CORRESPONDANT

(30) Priorität: 25.07.1996 DE 19630110
(43) Veröffentlichungstag der Anmeldung: 12.05.1999
(73) Patentinhaber: SIEMENS AKTIENGESELLSCHAFT, 80333 München (DE)
(72) Erfinder: BRUCHHAUS, Rainer, D-80997 München (DE); PITZER, Dana, D-85716 Unterschlei heim (DE)
(86) Internationale Anmeldenummer: DE9701396
(87) Internationale Veröffentlichungsnummer: WO98005062

(56) Entgegenhaltungen:
- EP-A- 0 698 918
- US-A- 5 654 222

## Beschreibung

Ferroelektrische Schichten finden in Bauelementen Verwendung, wobei die dielektrischen, pyroelektrischen und piezoelektrischen Eigenschaften von Ferroelektrika genutzt werden. Bauelemente mit ferroelektrischen Schichten sind beispielsweise Kondensatoren, Pyrodetektoren, Piezoaktoren oder Halbleiterspeicher, wobei die ferroelektrischen Schichten in letzteren sowohl als Dielektrikum als auch als Speichermedium unter Ausnutzung des Hystereseeffekts bei der Polarisierung eingesetzt werden können.

Aus EP 0 698 918 A ist beispielsweise eine mikroelektronische Schichtstruktur bekannt, die aus einem oxidierbaren Substrat, einer Elektrode und einem Dielektrikum mit hoher Dielektrizitätszahl besteht. Zwischen der Elektrode und dem Substrat ist eine Isolierschicht angeordnet. Die Isolierschicht, die beispielsweise aus einer Edelmetall-Isolator-Legierung besteht und elektrisch leitfähig sein muß, hat vor allen Dingen die Aufgabe, die Diffusion von Sauerstoff auf die Oberfläche des Substrats einzuschränken.

Hohe Bedeutung haben Bauelemente mit Dünnschichten aus Ferroelektrika erlangt, die in hoher struktureller Güte hergestellt werden können. Üblicherweise wird dazu auf einem Substrat eine erste Elektrodenschicht und darüber die ferroelektrische Schicht in herkömmlichen Dünnschichtverfahren erzeugt. Für die unterhalb der ferroelektrischen Schicht liegende Elektrode ist als Elektrodenmaterial Platin besonders geeignet, da es die Abscheidebedingungen der ferroelektrischen Schicht bei hohen Temperaturen und in sauerstoffhaltiger Atmosphäre unbeschadet übersteht und zu keiner Diffusion in die ferroelektrische Schicht führt, die zu einer veränderten Zusammensetzung und damit zu veränderten Eigenschaften führen könnte.

Bei der Verwendung siliziumhaltiger Substrate ergibt sich das Problem, daß Platin eine nur geringe Haftung auf Siliziumoxid zeigt. Zur Herstellung von Speicherkondensatoren mit Platinelektroden wurden daher bereits Haftvermittlerschichten aus Titan vorgeschlagen, die zwischen Platinelektrode und siliziumoxidhaltiger Substratoberfläche angeordnet sind (siehe zum Beispiel H. N. Al-Shareef et al, Proc. 4th International Symposium on Integrated Ferroelectrics, March 9-11, 1992, Seiten 181-196, Montery, CA, USA).

Mit titanhaltigen Haftvermittlerschichten sind jedoch eine Reihe von Nachteilen verbunden, die zu einer Verschlechterung der elektrischen Eigenschaften von ferroelektrischen Kondensatoren und allgemein von ferroelektrischen Bauelementen führen. Gute ferroelektrische Eigenschaften werden nur mit kristallinen Oxiden enthaltenden Ferroelektrika erhalten, deren Herstellung bei erhöhten Temperaturen in sauerstoffhaltiger Atmosphäre erfolgt. Hierbei wird jedoch eine Diffusion von Titan ins Platin hinein und daran anschließend eine Oxidation des Titans zu Titanoxid TiO₂ beobachtet. Dies ist mit einer relativ hohen Volumenausdehnung verbunden, die zur Bildung sogenannter Hillocks auf der Oberfläche der Platinelektrode führt. Diese Strukturunebenheiten setzen sich in einer darüber aufgebrachten ferroelektrischen Schicht fort, führen dort zu einer ungünstigen Morphologie und damit zu ungünstigeren elektrischen und ferroelektrischen Eigenschaften. Im Extremfall ist die Strukturunebenheit der Platinelektrode so groß, daß es im ferroelektrischen Bauelement zu einem Kurzschluß und damit zu einem Totalausfall des Bauelements kommt.

Aufgabe der vorliegenden Erfindung ist es daher, einen Schichtaufbau mit einer ferroelektrischen Schicht anzugeben, die eine gute und ebene Oberflächenmorphologie sowie eine gute Haftung auf dem Substrat aufweist.

Diese Aufgabe wird erfindungsgemäß durch einen Schichtaufbau nach Anspruch 1 gelöst. Vorteilhafte Ausgestaltungen der Erfindung sowie ein Verfahren zur Herstellung des Schichtaufbaus sind weiteren Ansprüchen zu entnehmen.

Überraschend wurde festgestellt, daß ein auf einem Substrat angeordneter Schichtaufbau mit einer amorphen Aluminiumoxidzwischenschicht, einer Platinschicht und darüber einer ferroelektrischen Schicht zum einen eine sehr gute Haftung aufweist und zum andern eine ferroelektrische Schicht mit sehr guter Oberflächenmorphologie ergibt. Die Oberfläche der ferroelektrischen Schicht ist frei von Hillocks und zeigt gegenüber einem Aufbau mit titanhaltiger Zwischenschicht eine regelmäßigere homogenere Kornstruktur. Eine ferroelektrische Schicht mit einem homogeneren Aufbau zeigt aber bessere ferroelektrische Eigenschaften, ist leichter polarisierbar und ermöglicht einen höheren dauerhaften Polarisierungsgrad als eine ferroelektrische Schicht mit inhomogenerer Struktur.

Unter amorpher Aluminiumoxidschicht wird dabei eine in einem Dünnschicht-Abscheideverfahren hergestellte Al₂O₃-Schicht verstanden, die auch mikrokristallin sein kann. Der Grad der (Mikro-)Kristallinität ist dabei abhängig von den gewählten Abscheidetemperaturen (Substrattemperaturen), die zum Beispiel bis 300°C betragen können.

Mit dem erfindungsgemäßen Schichtaufbau und der dabei erzielten homogenen Oberflächenmorphologie der ferroelektrischen Schicht ist es möglich, die ferroelektrische Schicht in ferroelektrischen Bauelementen dünner zu gestalten als bisher bekannt. Selbst bei dünnen ferroelektrischen Schichten muß kein Kurzschluß aufgrund von Strukturunebenheiten befürchtet werden. Auch ist es mit der Erfindung möglich, ferroelektrische Mehrschichtbauelemente, beispielsweise Kondensatoren im Mehrschichtbauweise in einfacher Weise herzustellen, ohne daß sich die Strukturunebenheiten der einzelnen Schichten mit zunehmender Anzahl der Schichten im Stapel potenzieren. Ein ferroelektrischer Kondensator mit einem erfindungsgemäßen Schichtaufbau läßt sich mit dünnerer ferroelektrischer Schicht und damit mit höherer Kapazität herstellen als mit einem bekannten Schichtaufbau.

Das Aluminiumoxid der Zwischenschicht zeigt keine Diffusion in die benachbarte Platinschicht und übersteht die Herstelltemperatur von ferroelektrischen Schichten von bis zu über 800°C in oxidierender Atmosphäre mühelos. Es ist auch chemisch so inert, daß Reaktionen mit Bestandteilen des Ferroelektrikums, die selbst durch die Platinschicht hindurchdiffundieren können, nicht zu befürchten sind.

Eine vorteilhafte Wirkung entfaltet eine Zwischenschicht bereits ab einer Schichtdicke von ca. 10 nm. Eine bevorzugte Schichtdicke für die Zwischenschicht liegt zwischen 20 und 120 nm. Höhere Schichtdicken für die Zwischenschicht sind weder erforderlich noch gewünscht, da mit zunehmender Schichtdicke der Zwischenschicht wieder Nachteile auftreten können. Eine dünnere Zwischenschicht ist schneller und kostengünstiger aufzubringen, während eine höhere Schichtdicke eine höhere Wärmekapazität und auch eine erhöhte Wärmeableitungskapazität besitzt, die in pyroelektrischen Bauelementen von Nachteil ist.

Eine Zwischenschicht aus Aluminiumoxid führt bei allen herkömmlichen Substratmaterialien zu einer verbesserten Haftung, insbesondere jedoch bei Substraten, deren Oberflächen Siliziumoxid oder Siliziumnitrid umfassen. Damit ist die Erfindung besonders geeignet für alle ferroelektrischen Schichtaufbauten und daraus hergestellten Bauelemente über Siliziumsubstraten, die üblicherweise eine Siliziumoxidoberflächenschicht aufweisen. Auch Pyrodetektoren, die über einer Siliziumnitrid umfassenden Membranschicht aufgebaut sind, werden mit der Erfindung vorteilhaft verwirklicht.

Zur Aufbringung der Zwischenschicht aus Aluminiumoxid wird ein Dünnschichtverfahren, vorzugsweise Sputtern, eingesetzt. Die Substrattemperatur wird dabei beispielsweise auf 200 bis 300°C eingestellt.

Die Platinschicht kann ebenfalls in beliebigen Dünnschichtverfahren aufgebracht werden, beispielsweise durch Aufdampfen, Elektronenstrahlverdampfen oder vorzugsweise durch (BIAS-) Sputtern. Bei einer Substrattemperatur von beispielsweise 100 bis ca. 300°C wird auf diese Weise eine Platinschicht mit (111)-Textur erhalten. Diese Textur wiederum ermöglicht ein ebenfalls texturiertes und dichtes Aufwachsen einer ferroelektrischen Schicht über der Platinschicht. Bei einer Temperatur von mindestens 450°C in sauerstoffhaltiger Atmosphäre gelingt das Erzeugen einer bereits nach dem Sputtern selbst-polarisierten ferroelektrischen Schicht. Prinzipiell sind jedoch zur Herstellung der ferroelektrischen Schicht auch andere Verfahren möglich, beispielsweise CVDund Sol-Gel-Verfahren.

Die Verwendung eines Sputterverfahrens zur Aufbringung der Zwischenschicht und der Platinschicht hat den Vorteil, daß Zwischenschicht und Platinschicht in derselben Sputteranlage aufgebracht werden können. Ein Herausnehmen der Substrate aus der Anlage könnte andernfalls an der Atmosphäre zur Ausbildung unerwünschter monomolagiger Schichten führen, die negative Auswirkungen für die Zusammensetzung und Eigenschaften des Schichtaufbaus zur Folge haben könnten.

Im folgenden wird die Erfindung anhand eines Ausführungsbeispiels und der dazugehörigen drei Figuren näher erläutert.
- Figur 1: zeigt einen erfindungsgemäßen Schichtaufbau im schematischen Querschnitt.
- Figur 2: zeigt die REM-Aufnahme von der Oberfläche eines erfindungsgemäßen Schichtaufbaus und
- Figur 3: zeigt die Oberfläche eines aus dem Stand der Technik bekannten Schichtaufbaus mit titanhaltiger Zwischenschicht.

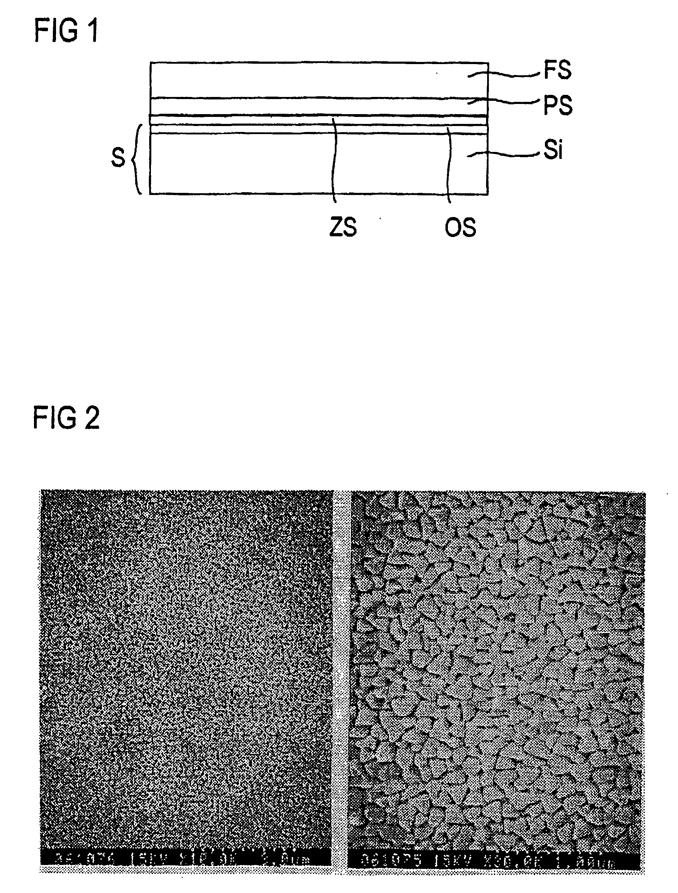

Figur 1: Als Substrat S wird ein beliebiges Substrat, beispielsweise Silikatglas oder ein Siliziumwafer Si verwendet. Dieser kann eine Oberflächenschicht OS aus Siliziumoxid SiO₂ oder aus Siliziumnitrid Si₃N₄ umfassen. Die Dicke dieser Oberflächenschicht OS ist für die Haftung und die Morphologie der darüber aufzubringenden Schichten ohne Bedeutung.

Ober der Oberflächenschicht OS wird die Zwischenschicht ZS in einer Dicke von 10 bis ca. 120 nm aufgebracht, beispielsweise durch Sputtern von Al₂O₃ bei 100° bis ca. 300°C Substrattemperatur.

Darüber wird die Platinschicht PS aufgebracht, vorzugsweise ebenfalls durch Sputtern bei einer Substrattemperatur von mindestens 100° bis ca. 300°C. In Abhängigkeit von der gewünschten Verwendung des Schichtaufbaus wird die Platinschicht PS in einer geeigneten Schichtdicke aufgebracht, in allen Fällen aber mit möglichst geringer Schichtdicke von beispielsweise 0,1 bis 0,5 µm.

Die darüber aufgebrachte ferroelektrische Schicht FS besteht aus einem ferroelektrischen Material, vorzugsweise aus der Klasse der bleihaltigen Titanate, die noch verschiedene Zuschläge aus der Klasse der Erdalkalimetalle oder Zirkonium aufweisen können. Bekanntester Vertreter dieser mit Perowskit-Struktur erzeugbaren ferroelektrischen Materialien ist Bleizirkonattitanat (PZT). Für die Haftung und die Morphologie der ferroelektrischen Schicht FS ist deren Dicke ohne Bedeutung. Für ferroelektrische Bauelemente ist eine Schichtdicke der ferroelektrischen Schicht von 200 nm bis ca. 2 µm ausreichend.

Figur 2 zeigt in einer REM-Aufnahme die Oberflächenstruktur der ferroelektrischen Schicht des erfindungsgemäßen Schichtaufbaus in zwei Auflösungen.

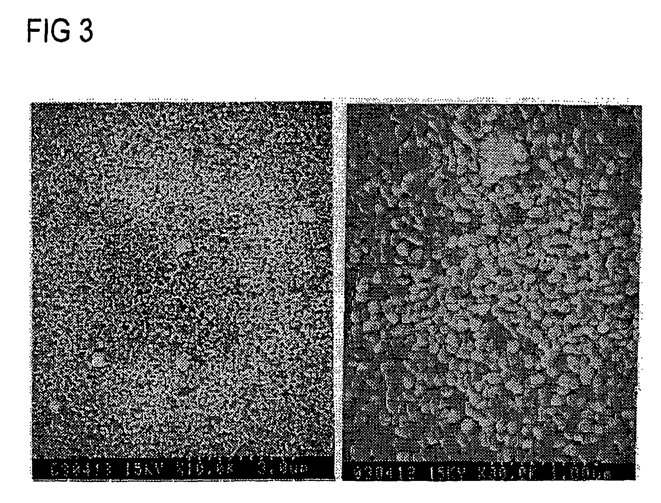

Zum Vergleich ist in Figur 3 die Oberflächenstruktur einer ferroelektrischen Schicht eines bekannten Schichtaufbaus mit einer titanhaltigen Zwischenschicht als REM-Aufnahme abgebildet. Wie der direkte Vergleich deutlich macht, weist die ferroelektrische Schicht des erfindungsgemäßen Schichtaufbaus (Figur 2) eine homogenere Kornstruktur und keinerlei Strukturverwerfungen (Hillocks) auf. Die Oberflächenstruktur des bekannten Schichtaufbaus (Figur 3) ist dagegen deutlich inhomogen und zeigt zugleich einige Hillocks, die in Form von besonders großen, die Oberfläche überragenden Körnern die Ebenheit der Oberfläche stark beeinträchtigen.

## Patentansprüche

1. Schichtaufbau mit zumindest
- einem Substrat (S)
- einer Platinschicht (PS)
- einer auf der Platinschicht (PS) angeordneten ferroelektrischen Schicht (FS)
bei dem zwischen Substrat (S) und Platinschicht (PS) eine Zwischenschicht (ZS) aus amorphem Al₂O₃ angeordnet ist.

2. Schichtaufbau nach Anspruch 1,
bei dem die Oberfläche (OS) des Substrats (S) Siliziumdioxid umfaßt.

3. Schichtaufbau nach Anspruch 1 oder 2,
bei dem das Substrat (S) monokristallines Silizium mit einer Oberflächenschicht (OS) aus Siliziumdioxid umfaßt.

4. Schichtaufbau nach einem der Ansprüche 1 bis 3,
bei dem die Zwischenschicht (ZS) eine Schichtdicke von 10 bis ca.1000 nm besitzt.

5. Schichtaufbau nach einem der Ansprüche 1 bis 4,
bei dem die ferroelektrische Schicht (FS) aus dem Stoffsystem Pb(Zr,Ti)O₃ ausgewählt ist.

6. Verfahren zur Herstellung eines Schichtaufbaus mit einem Substrat (S), einer Platinschicht (PS) und einer auf der Platinschicht angeordneten ferroelektrischen Schicht (FS), bei dem zwischen Substrat und Platinschicht eine Zwischenschicht (ZS) aus Al₂O₃ in einem Dünnschichtverfahren abgeschieden wird.

7. Verfahren nach Anspruch 6,
bei dem die Zwischenschicht (ZS) bei einer Substrattemperatur von 100 bis 300°C abgeschieden wird.

8. Verfahren nach Anspruch 6 oder 7,
bei dem die ferroelektrischen Schicht (FS) bei einer Substrattemperatur von zumindest 450°C in einem Sauerstoff haltigen Plasma abgeschieden wird.

9. Verfahren nach einem der Ansprüche 6 bis 8,
bei dem die Platinschicht (PS) bei einer Substrattemperatur von 100 bis 300°C abgeschieden wird.

10. Verwendung eines Schichtaufbaus nach einem der Ansprüche 1 bis 5 zur Herstellung ferroelektrischer Dünnschichtbauelemente, wie Pyrodetektoren, Kondensatoren oder Speicher.

## Claims

1. Layer structure having at least
- a substrate (S)
- a platinum layer (PS)
- a ferroelectric layer (FS) arranged on the platinum layer (PS)
in which an intermediate layer (ZS) of amorphous Al₂O₃ is arranged between the substrate (S) and the platinum layer (PS).

2. Layer structure according to Claim 1, wherein the surface (OS) of the substrate (S) comprises silicon dioxide.

3. Layer structure according to Claim 1 or 2, in which the substrate (S) comprises monocrystalline silicon having a surface layer (OS) of silicon dioxide.

4. Layer structure according to one of Claims 1 to 3, in which the intermediate layer (ZS) has a thickness of from 10 to about 1000 nm.

5. Layer structure according to one of Claims 1 to 4, in which the ferroelectric layer (FS) is selected from the material system Pb(Zr,Ti)O₃.

6. Process for the production of a layer structure having a substrate (S), a platinum layer (PS) and a ferroelectric layer (FS) arranged on the platinum layer, in which an intermediate layer (ZS) of Al₂O₃ is deposited between the substrate and the platinum layer using a thin-film process.

7. Process according to Claim 6, in which the intermediate layer (ZS) is deposited when the substrate temperature is from 100 to 300°C.

8. Process according to Claim 6 or 7, in which the ferroelectric layer (FS) is deposited in an oxygen-containing plasma when the substrate temperature is at least 450°C.

9. Process according to one of Claims 6 to 8, in which the platinum layer (PS) is deposited when the substrate temperature is from 100 to 300°C.

10. Use of a layer structure according to one of Claims 1 to 9 for the production of ferroelectric thin-film components, for example pyrodetectors, capacitors and memories.

## Revendications

1. Montage stratiforme comprenant au moins
- un substrat (S)
- une couche de platine (PS)
- une couche ferroélectrique (FS) disposée sur la couche de platine (PS)
dans lequel une couche intermédiaire (ZS) en Al₂O₃ amorphe est disposée entre le substrat (S) et la couche de platine (PS).

2. Montage stratiforme selon la revendication 1,
dans lequel la surface (OS) du substrat (S) comprend du dioxyde de silicium.

3. Montage stratiforme selon l'une quelconque des revendications 1 ou 2,
dans lequel le substrat (S) comprend du silicium monocristallin avec une couche de surface (OS) en dioxyde de silicium.

4. Montage stratiforme selon l'une quelconque des revendications 1 à 3,
dans lequel la couche intermédiaire (ZS) présente une épaisseur de 10 à environ 1000 nm.

5. Montage stratiforme selon l'une quelconque des revendications 1 à 4,
dans lequel la couche intermédiaire ferroélectrique (FS) est choisie dans le système de matières Pb (Zr, Ti)O₃.

6. Procédé de fabrication d'un montage stratiforme comprenant un substrat (S), une couche en platine (PS), et une couche ferroélectrique (FS) disposée sur la couche en platine, dans lequel une couche intermédiaire (ZS) en Al₂O₃ est déposée entre le substrat et la couche de platine, dans un procédé par couches minces.

7. Procédé selon la revendication 6,
dans lequel la couche intermédiaire (ZS) est déposée à une température du substrat située entre 100 et 300° C.

8. Procédé selon l'une quelconque des revendications 6 ou 7,
dans lequel la couche ferroélectrique (FS) est déposée à une température de substrat d'au moins 450° C, dans un plasma oxygéné.

9. Procédé selon l'une quelconque des revendications 6 à 8,
dans lequel la couche de platine (PS) est déposée à une température de substrat située entre 100 et 300 °C.

10. Utilisation d'un montage stratiforme selon l'une quelconque des revendications 1 à 5 pour la fabrication d'éléments ferroélectriques en couches minces, tels que les détecteurs pyroélectriques, les condensateurs ou les mémoires.
